(19) Europäisches Patentamt
European Patent Office
Office européen des brevets

(11) EP 3 260 487 A1

(12) **EUROPÄISCHE PATENTANMELDUNG**

(43) Veröffentlichungstag:
**27.12.2017 Patentblatt 2017/52**

(51) Int Cl.:
***C08K 5/29*** *(2006.01)* ***C08J 5/18*** *(2006.01)*
***C08L 67/02*** *(2006.01)* ***C08L 79/00*** *(2006.01)*

(21) Anmeldenummer: **16175623.4**

(22) Anmeldetag: **22.06.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **LANXESS Deutschland GmbH**
**50569 Köln (DE)**

(72) Erfinder: **Laufer, Wilhelm**
**67158 Ellerstadt (DE)**

(54) **HYDROLYSESTABILE ZUSAMMENSETZUNGEN FÜR FOLIEN IN SOLARZELLEN**

(57) Die vorliegenden Erfindung betrifft neue hydrolysestabile Zusammensetzungen, insbesondere für Folien in Solarzellen, die sich durch eine verbesserte Hydrolysebeständigkeit auszeichnen, sowie die Solarzellen, enthaltend diese Folien.



Printed by Jouve, 75001 PARIS (FR)

**Beschreibung**

Die vorliegenden Erfindung betrifft neue hydrolysestabile Zusammensetzungen, insbesondere für Folien in Solarzellen, die sich durch eine verbesserte Hydrolysebeständigkeit auszeichnen, sowie die Solarzellen, enthaltend diese Folien.

Die Stromerzeugung mittels Photovoltaik hat nach dem beschlossenen deutschlandweiten Ausstieg aus der Kernenergie einen Aufschwung erfahren.

Bei der photovoltaischen Stromerzeugung wird bekanntermaßen Sonnenenergie mittels eines Siliziumzellen-Halbleiters direkt in elektrische Energie umgewandelt. Dieses Solarzellenelement erfährt allerdings eine Qualitätsminderung, wenn es in direkten Kontakt mit der Umgebungsluft gebracht wird. Darum wird ein Solarzellenelement im Allgemeinen zwischen einem Dichtungsmaterial und einem transparenten Oberflächenschutzmaterial (meistens Glas) und einem rückseitigen Oberflächenschutzmaterial (einer Rückseitenfolie zum Beispiel aus einem Polyesterharz, einem Fluorharz oder dergleichen) angeordnet, um eine Pufferwirkung zu erzielen und das Eindringen von Fremdkörpern und vor allem das Eindringen von Feuchtigkeit zu verhindern.

Fluorharze (Kunststoffe auf Basis von Polyvinylfluorid) eignen sich aufgrund ihrer Inertheit besonders für dieses Einsatzgebiet, allerdings sind diese so teuer in der Herstellung und häufig nicht in ausreichender Menge verfügbar, so das auf hydrolyseinstabile Polyesterharze ausgewichen wird. Die Entwicklungsarbeiten gehen daher vorrangig in Richtung Hydrolyseschutz der Polyesterharzschicht.

Zu diesem Zweck werden z.B. polymere Carbodiimide eingesetzt, die zahlenmittleren Molmassen von 2000 - 100000 aufweisen siehe EP-A 2262000. Dabei sind vor allem aliphatische Carbodiimide, wie z.B. Carbodilite® LA-1 bzw. Carbodilite® HMV-8CV, bevorzugt. Diese haben allerdings den Nachteil, ungenügend oder nur in hohen Konzentrationen als Hydrolyseschutzmittel zu wirken. Aromatischen Polycarbodiimide mit sehr hohen Molekularmassen, zeigen zwar einen guten Hydrolyseschutz in PET (siehe EP-A-2748234) jedoch nicht ausreichend in den biobasierten Kunstoffen wie z. B. Polylactiden (PLA) und sind aufgrund der aufwendigen Herstellung sehr teuer in der Anschaffung. Darüber hinaus führen deren Einsatz zu einer immer noch nicht zufriedenstellenden Emission von Isocyanaten, was eine großtechnische Herstellung von Folien ohne weiteres nicht möglich macht.

Die Aufgabe der vorliegenden Erfindung bestand somit darin, Zusammensetzungen für Folien für Solarzellen auf Basis von Polyester bereitzustellen, die die Nachteile des Standes der Technik nicht aufweisen und vor allem kosteneffizient und hydrolysestabil sind.

Überraschenderweise wurde nun gefunden, dass eine Zusammensetzung, enthaltend mindestens einen Polyester und mindestens ein polymeres Carbodiimid nach Formel (I)

$$R^1\text{-}R^2\text{-}(\text{-}N{=}C{=}N\text{-}R^2\text{-})_m\text{-}R^1 \qquad (I),$$

in dem

m = 2 bis 10, bevorzugt 3 bis 6, ganz besonders bevorzugt 3 bis 4, wobei

$R^1$ = -NHCONH$R^3$, -NHCON$R^3R^4$ oder -NHCOO$R^5$ ist, und

wobei $R^3$ und $R^4$ gleich oder verschieden sind und einen $C_1$-$C_{12}$-Alkyl-, $C_6$-$C_{12}$-Cycloalkyl-, $C_7$-$C_{18}$-Aralkyl- oder Arylrest darstellen und

$R^5$ einem $C_1$ - $C_{22}$ - Alkyl-, $C_6$ - $C_{12}$ -Cycloalkyl-, $C_6$ - $C_{18}$ -Aryl oder $C_7$ - $C_{18}$ -Aralkylrest, sowie einem ungesättigten Alkylrest mit 2 - 22 oder ein Alkoxypolyoxyalkylenrest entspricht,
und

$R^2$ = $C_6$ - $C_{18}$ -Arylen, $C_1$-$C_{12}$- Alkyl und/oder $C_6$- $C_{18}$ -Aryl-substituierte $C_6$-$C_{30}$-Arylene, vorzugsweise

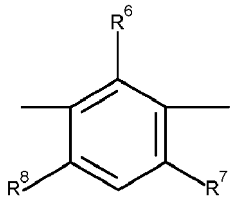
,

wobei $R^6$, $R^7$ und $R^8$ jeweils unabhängig für Methyl- oder Ethyl steht, aber nur maximal einer der Reste $R^6$, $R^7$ und $R^8$

Methyl ist,
mit einer zahlenmittleren Molmasse $M_n$ von > 1000 bis < 2000 g/mol, bestimmt mittels GPC, gemessen in Tetrahydrofuran (THF) gegen Polystyrol als Standard, die Nachteile des Standes der Technik nicht aufweist.

Gegenstand der vorliegenden Erfindung sind daher Zusammensetzungen, enthaltend mindestens einen Polyester und mindestens ein polymeres Carbodiimid nach Formel (I)

$$R^1\text{-}R^2\text{-}(\text{-}N{=}C{=}N\text{-}R^2\text{-})_m\text{-}R^1 \qquad \text{(I)},$$

in dem

m = 2 bis 6, bevorzugt 3 bis 5, ganz besonders bevorzugt 3 bis 4, wobei

$R^1$ = -NHCONHR$^3$, -NHCONR$^3$R$^4$ oder -NHCOOR$^5$ ist,

wobei $R^3$ und $R^4$ gleich oder verschieden sind und einen $C_1$-$C_{12}$-Alkyl-, $C_6$-$C_{12}$-Cycloalkyl-, $C_7$-$C_{18}$-Aralkyl- oder Arylrest darstellen und

$R^5$ einem $C_1$ - $C_{22}$ - Alkyl-, $C_6$ - $C_{12}$ -Cycloalkyl-, $C_6$ - $C_{18}$ -Aryl oder $C_7$ - $C_{18}$ -Aralkylrest, sowie einem ungesättigten Alkylrest mit 2 - 22 oder einem Alkoxypolyoxy-$C_1$-$C_{12}$-alkylenrest entspricht,

$R^2$ = $C_6$ - $C_{18}$ -Arylen, $C_1$-$C_{12}$- Alkyl und/oder $C_6$- $C_{18}$ -Aryl-substituierte $C_6$-$C_{30}$-Arylene, vorzugsweise

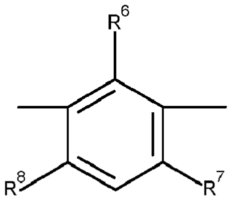
,

wobei $R^6$, $R^7$ und $R^8$ jeweils unabhängig für Methyl- oder Ethyl steht, aber nur maximal einer der Reste $R^6$, $R^7$ und $R^8$ Methyl ist,
mit einer zahlenmittleren Molmasse $M_n$ von > 1000 bis < 2000 g/mol, bevorzugt 1300 bis 1750 g/mol, bestimmt mittels GPC, gemessen in Tetrahydrofuran (THF) gegen Polystyrol als Standard.

Ausgewertet wurden die Messungen der zahlenmittleren Molmasse mit einer Kombination von RI-Detektor (Brechungsindex und Viskositätsdetektor (universelle Kalibrierung).

In einer bevorzugten Ausführungsform der vorliegenden Erfindung handelt es sich bei dem polymeren Carbodiimid um eine Verbindung der Formel (II)

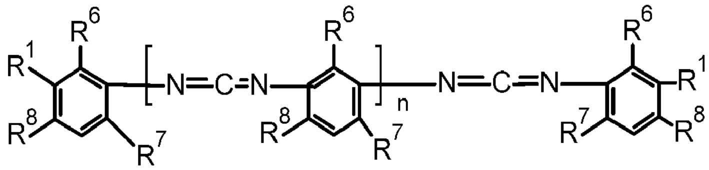
(II)

bei denen $R^1$ innerhalb des Moleküle gleich oder verschieden sein können und ausgewählt werden aus der Gruppe der NHCONHR$^3$, -NHCONR$^3$R$^4$ oder -NHCOOR$^5$,

wobei $R^3$ und $R^4$ gleich oder verschieden sind und einen $C_1$-$C_{12}$-Alkyl-, $C_6$-$C_{12}$-Cycloalkyl-, $C_7$ - $C_{18}$ -Aralkylrest - oder Arylrest darstellen,

$R^5$ einem $C_1$ - $C_{22}$ - Alkyl-, $C_6$ - $C_{12}$ -Cycloalkyl-, $C_6$ - $C_{18}$ -Aryl oder $C_7$ - $C_{18}$ -Aralkylrest, sowie einem ungesättigten Alkylrest mit 2 - 22, bevorzugt 12-20, besonders bevorzugt 16-18 Kohlenstoffatomen, oder ein Alkoxypolyoxy-$C_1$-$C_{12}$-alkylenrest entspricht,

$R^6$, $R^7$ und $R^8$ jeweils unabhängig für Methyl- oder Ethyl stehen, wobei aber nur maximal einer der Reste $R^6$, $R^7$ und $R^8$ Methyl ist und n = 1 bis 5 bedeutet.

In einer besonders bevorzugten Ausführungsform der Erfindung sind in dem polymeren aromatischen Carbodiimid der Formel (II) mit n = 3 und $R^1$ = -NHCOOR$^5$ mit $R^5$ = Cyclohexyl, und wobei $R^6$, $R^7$ und $R^8$ für Methyl- oder Ethyl steht, unter der Maßgabe, dass nur maximal einer der Reste $R^6$, $R^7$ und $R^8$ Methyl ist. Des Weiteren bevorzugt ist, dass es sich bei n = 3 um einen arithmetischen Mittelwert der Messungen handelt.

In einer Ausführungsform der Erfindung handelt es sich bei den bei für m und n in Formel (I) bzw. (II) angegebenen Zahlenwerten um arithmetische Mittelwerte.

Die Ermittlung der zahlenmittleren Molmassen Mn erfolgte mittels GPC (Gel-Permeations-Chromatographie), gemessen in Tetrahydrofuran (THF) gegen Polystyrol als Standard. Ausgewertet wurde dies mit einer Kombination von RI-Detektor (Brechungsindex) und Viskositätsdetektor (universelle Kalibrierung). Die Kalibrierung mit Polystyrol erfolgte mit Referenz-Polystyrolen verschiedener Molmassen von der zertifizierten Firma PSS Polymer Standards Service GmbH.

Bei den polymeren Carbodiimiden im Sinne der Erfindung handelt es sich vorzugsweise um aromatische polymere Carbodiimide der Formel (I) mit einer zahlenmittleren Molmasse $M_n$ von > 1000 bis < 2000 g/mol. Diese sind handelsüblich und sind z. B. bei der Firma Rhein Chemie Rheinau GmbH erhältlich.

Der Carbodiimid-Gehalt (NCN-Gehalt, gemessen durch Titration mit Oxalsäure) der erfindungsgemäß eingesetzten Carbodiimide liegt vorzugsweise bei 2 - 12 Gew.%, bevorzugt 4 - 8 Gew.%, besonders bevorzugt bei 5 - 7 Gew.%.

In einer Ausführungsform der vorliegenden Erfindung handelt es sich bei dem Polyester um Polyethylenterephthalat (PET), Polyethylennaphthalat (PEN), Polybutylenterephthalat (PBT), Polytrimethyleneterephthalat (PTT) und/oder Polycyclohexandimethanol-terephthalat (PCT), esterbasierte thermoplastische Elastomere wie TPE-U oder TPE-E sowie biobasierte und/oder bioabbaubare bzw. kompostierbare Polyester wie z. B. Ecoflex der Fa. BASF, Polybutylenadipattherephthalat PBAT (Ecovio der Fa. BASF), Polylactide (PLA, z. B. der Natureworks oder Polyhydroxyalkoholate (PHA). Dabei sind Polyethylenterephthalat (PET), Polybutylenadipattherephthalat (PBAT) und Polylactid (PLA) besonders bevorzugt.

In einer weiteren Ausführungsform der Erfindung handelt es sich bei dem Polyester um ein Gemisch aus Polyestern. In diesem Zusammenhang ist ein Gemisch aus Polyethylenterephthalat (PET) und Polyethylennaphthalat (PEN) sowie ein Gemisch aus Polyethylenterephthalat (PET) und Polylactid (PLA) bevorzugt.

Bei den Polyestern handelt es sich um handelsüblich Substanzen, die z.B. bei den Firmen Invista, Novapet S. A., BASF, NatureWorks erhältlich sind.

In einer weiteren bevorzugten Ausführungsform der Erfindung beträgt die Menge an polymerem Carbodiimid der Formel (I), bezogen auf den Polyester, 0,5 - 2,5 Gew.%, bevorzugt 1,0 - 2,0 Gew.%.

Weiterer Gegenstand der vorliegenden Erfindung sind Folien, enthaltend die erfindungsgemäße Zusammensetzung.

Die erfindungsgemäßen Folien können auch weitere Additive enthalten, wie z.B. Pigmente, Farben, Füllstoffe, Stabilisatoren, Antioxidantien, Weichmacher, Verarbeitungshilfsstoffe, Vernetzer etc.

Die Herstellung der erfindungsgemäßen Folie erfolgt vorzugsweise nach dem folgenden Verfahren.

In einer Ausführungsform der Erfindung wird das polymere Carbodiimid der Formel (I) oder (II) mit einer zahlenmittleren Molmasse $M_n$ von > 1000 bis < 2000 g/mol in der gewünschten Konzentration mittels Kneter und/oder Extruder in den Polyester eingearbeitet.

In einer weiteren Ausführungsform der Erfindung wird das polymere Carbodiimid der Formel (I) oder (II) in Form eines Polyester-haltigen Masterbatches mittels Kneter und/oder Extruder in den Polyester eingearbeitet. Dabei beträgt die Konzentration des Carbodiimids im Masterbatch vorzugsweise 10-20 Gew.%. Für die Herstellung sind vorzugsweise folgenden Geräte einsetzbar: Einwellen-, Doppelwellen- oder Mehrwellenextruder, Planetenextruder, Kaskadenextruder, kontinuierlich arbeitende Co-Kneter (Typ Buss) und diskontinuierlich arbeitende Kneter, z.B. Typ Banbury und andere in der Polymerindustrie übliche Aggregate.

Gegebenenfalls einzusetzenden Additive, Pigmente, Farben, Füllstoffe, Stabilisatoren, Antioxidantien, Weichmacher, Verarbeitungshilfsstoffe, Vernetzer werden vorzugsweise in einem Mischschritt mit dem polymeren Carbodiimid in den Polyester eingearbeitet. Die Dosierreihenfolge von Carbodiimid und Additiv kann dabei beliebig gewählt werden.

Die Herstellung der Folie erfolgt vorzugsweise durch Mischen von Carbodiimid oder Carbodiimid-Masterbatch und Polyester in Schmelze und anschließender Schmelzextrusion, siehe auch EP-A 2262000.

In einer bevorzugten Ausführungsform der Erfindung ist die Folie biaxial orientiert. In einer Ausführungsform der Erfindung wird die biaxial orientierte Folie hergestellt, indem eine dünne Schicht aus der erfindungsgemäßen geschmolzenen Zusammensetzung, beispielsweise mit PET als Polyester auf eine Walze aufgetragen wird, zuerst in Walzenrichtung und dann orthogonal zur Walzendrehrichtung gedehnt wird (BOPET).

In einer Ausführungsform der Erfindung wird die biaxial orientierte Folie auf einer BOPET-Maschine hergestellt, die um die Emission von giftigen Gasen während der Herstellung zu minimieren zum Teil oder vollständig abgeschlossen und/oder mit spezielle Ablufteinrichtungen versehen ist z. B. kommerziell erhältlich sind.

Die Folien können dabei in beliebiger Dicke hergestellt werden. Bevorzugt sind jedoch Schichtdicken zwischen 25 und 300 Mikrometer.

Gegenstand der vorliegenden Erfindung ist zudem die Verwendung der erfindungsgemäßen Folien in Solarzellen und dort vorzugsweise zum Abdichten und damit zum Schutz vor Umgebungseinflüssen, wie z.B. Feuchtigkeit und dem Eindringen von Fremdkörpern.

Gegenstand der vorliegenden Erfindung ist zudem ein Solarzellenmodul, enthaltend mindestens eine erfindungsgemäße Folie, vorzugsweise als Rückseitenabdeckung.

Solarzellen bestehen in der Regel aus mehreren Schichten aus unterschiedlichen Materialien, wie

- dem Frontglas, aus z.B. Glasscheiben oder transparenten Substraten, wie z.B. Polycarbonat,
- den Siliciumwafern, die einlaminiert sind in Einbettfolien, bestehend in der Regel in Ethylenvinylacetat,
- einer Rückseitenfolie aus Polyvinylfluorid und/oder Polyester und
- einem Aluminiumrahmen.

Zudem sind auch Solarzellen bekannt, in denen sich zwischen dem Frontglas und dem Siliciumwafer noch transparente Polymerschichten befinden, z.B. aus $\alpha$-Olefin-Vinylacetat-Copolymeren, mit Olefinen, ausgewählt aus Ethen, Propen, Buten, Penten, Hexen, Hepten und Octen, wie z.B. beschrieben in EP-A 2031662.

In der vorliegenden Erfindung wird die erfindungsgemäße Folie in Solarzellen als Rückseitenfolie eingesetzt. Dabei ist die Folie in allen im Stand der Technik bekannten Solarzellen einsetzbar.

Die Herstellung der Solarzelle erfolgt dabei nach den in dem Stand der Technik beschriebenen Verfahren, ausgehend von den Standardverfahren zur Herstellung von Silizium über Gießverfahren, Bridgeman Verfahren, EFG (edgedefined film-fed growth)-Verfahren oder dem Czochralski-Verfahren und der nachfolgenden Herstellung der Si-Wafer und dem Aufeinanderschichten der vorgenannten Materialschichten, wobei anstelle der standardmäßig eingesetzten Rückseitenfolie, die erfindungsgemäße Folie eingesetzt wird. Die einzelnen Schichten der Solarzelle können dabei auch in Laminierverfahren miteinander verbunden werden, siehe EP-A 2031662.

Der Rahmen der Erfindung erfasst alle oben stehenden und im Folgenden aufgeführten allgemeinen oder in Vorzugsbereichen genannten Restedefinitionen, Indizes, Parameter und Erläuterungen untereinander, also auch zwischen den jeweiligen Bereichen und Vorzugsbereichen in beliebiger Kombination.

Die nachfolgenden Beispiele dienen der Erläuterung der Erfindung, ohne dabei limitierend zu wirken.

**Ausführungsbeispiele:**

In den Beispielen wurden die folgenden Substanzen eingesetzt:

**PET** = Polyethylenterephthalat der Firma Invista, eingesetzt in den Beispielen 1 bis 5.

**PLA** = Polylactid (Polymilchsäure) der Fa. NatureWorks in den Beispielen 6 bis 16.

In den Bsp. Nr. 2 und 7 wurde das zuvor genannten PET bzw. PLA in einem Labordoppelschneckenextruder ZSK 25 der Firma Werner & Pfleiderer vor der unten beschriebenen Messung einmal extrudiert.

**CDI 1 (Vergleich)** = Bis-2,6-Diisopropylphenylcarbodiimid, ein monomeres aromatisches Carbodiimid mit einer zahlenmittleren Molmasse von Mn = 270 g/mol, und einem NCN-Gehalt von ca. 11 Gew.%, eingesetzt in den Beispielen 3, 8 und 13.

**CDI 2 (Vergleich)** = Ein polymeres aromatisches Carbodiimid der Formel

$$R^{10}\text{-}R^{9}\text{-}(\text{-}N{=}C{=}N\text{-}R^{9}\text{-})_{m}\text{-}R^{10}$$

mit $R^9$ = Triisopropylphenylen und $R^{10}$ = -NCNR$^9$ ist mit einer zahlenmittleren Molmasse von Mn = 1700 g/mol, und einem NCN-Gehalt von ca. 13 Gew.%, eingesetzt in den Beispielen 4, 9 und 14.

**CDI 3 (Vergleich)** = Ein polymeres aromatisches Carbodiimid der der Formel

$$R^{11}\text{-}R^{9}\text{-}(\text{-}N{=}C{=}N\text{-}R^{9}\text{-})_{m}\text{-}R^{11}$$

mit $R^9$ = Triisopropylphenylen und $R^{11}$ = -NCO ist mit einer zahlenmittleren Molmasse von ca. Mn = 5700 g/mol, und einem NCN-Gehalt von ca. 13,5 Gew.%, eingesetzt in den Beispielen 10 und 15.

**CDI 4 (erfindungsgemäß)** = polymeres aromatisches Carbodiimid der Formel (II) mit n = 3 als arithmetisches Mittelwert und $R^1$ = $-NHCOOR^5$ mit $R^5$ = Cyclohexyl, und $R^6$, $R^7$ = Ethyl und $R^8$ = Methyl- , mit einer zahlenmittlere Molmasse: ca. 1400 g/mol, und einem NCN-Gehalt von ca. 11 Gew.%, eingesetzt in den Beispielen 5, 11 und 16.

Die Einarbeitung der Carbodiimide in das PET und das PLA erfolgte mittels eines Labordoppelschneckenextruders ZSK 25 der Firma Werner & Pfleiderer.

Art und Menge des eingesetzten Carbodiimids ergeben sich aus Tabelle 1, ebenso wie die Messergebnisse in Bezug auf die Hydrolysestabilität.

Die für die Messung der Bruchdehnung verwendeten F3-Normprüfkörper wurden an einer Spritzgießmaschine des Typs Arburg Allrounder 320 S 150 - 500 erstellt.

Für den Hydrolysetest wurden diese F3-Normprüfkörper im Fall von PET bei einer Temperatur von 110°C in Wasserdampf und im Fall von PLA bei 65°C in Wasser für mehrere Tage gelagert und deren Bruchdehnung nach 0, 1, 3 und 5 Tagen im Fall von PET und 0, 1, 2, 3 und 6 Tagen im Fall von PLA gemessen.

Die Ermittlung der zahlenmittleren Molmassen erfolgte mittels GPC (Gel-Permeations-Chromatographie), gemessen in THF gegen Polystyrol als Standard, ausgewertet mit einer Kombination von RI-Detektor (Brechungsindex) und Viskositätsdetektor (universelle Kalibrierung). Zu diesem Zweck wurde ein Messgerät der Firma Thermo Scientific eingesetzt. Die Kalibrierung mit Polystyrol erfolgte mit Referenz-Polystyrolen verschiedener Molmassen von der zertifizierten Firma PSS Polymer Standards Service GmbH.

Die in Tabelle 1 und 2 angegebenen Werte für die Bruchdehnung ergeben sich aus der folgenden Berechnung:

$$\text{Bruchdehnung [\%]} = (\text{Bruchdehnung nach X Tagen} / \text{Bruchdehnung nach 0 Tagen}) \times 100$$

**Tabelle 1**

| **Bsp. Nr** | **1** | **2** | **3** | **4** | **5** |
|---|---|---|---|---|---|
| | V | V | V | V | E |
| **Menge CDI** [%] | 0 | 0 | 1,5 | 1,5 | 1,5 |
| **CDI** | - | - | **CDI 1** | **CDI 2** | **CDI 4** |
| **Bruchdehnung** [%] **(X = 1 Tag)** | 80 | 69 | 100 | 88 | 100 |
| **Bruchdehnung** [%] **(X = 3 Tage)** | 30 | 0 | 61 | 37 | 95 |
| **Bruchdehnung** [%] **(X = 5 Tage)** | 0 | 0 | 40 | 0 | 52 |
| V = Vergleichsversuch,<br>E = erfindungsgemäß | | | | | |

**Tabelle 2**

| **Bsp. Nr** | **6** | **7** | **8** | **9** | **10** | **11** |
|---|---|---|---|---|---|---|
| | V | V | V | V | V | E |
| **Menge CDI** [%] | 0 | 0 | 1,5 | 1,5 | 1,5 | 1,5 |
| **CDI** | - | - | **CDI 1** | **CDI 2** | **CDI 3** | **CDI 4** |
| **Bruchdehnung** [%] **(X = 1 Tag)** | 64 | 55 | 100 | 100 | 100 | 100 |
| **Bruchdehnung** [%] **(X = 2 Tage)** | 12 | 0 | 100 | 100 | 90 | 100 |
| **Bruchdehnung** [%] **(X= 3 Tage)** | 0 | 0 | 61 | 100 | 28 | 100 |

(fortgesetzt)

| **Bsp. Nr** | **6** | **7** | **8** | **9** | **10** | **11** |
|---|---|---|---|---|---|---|
| **Bruchdehnung** [%] **(X= 6 Tage)** | 0 | 0 | 0 | 0 | 0 | 89 |
| V = Vergleichsversuch,<br>E = erfindungsgemäß | | | | | | |

Es zeigt sich, dass bei der Verwendung der erfindungsgemäßen Carbodiimide trotz der niedrigen zahlenmittleren Molmasse die höchste Hydrolysestabilität erreicht werden kann.

Messung der Emission (Off-gassing)

Die Abluftmessung zur Ermittlung der Isocyanat-Emission erfolgte während der Einarbeitung der Carbodiimide in das Polylactid (PLA) mittels eines Labordoppelschneckenextruders ZSK 25 der Firma Werner & Pfleiderer.
Dazu wurde ein Teil des Abluftstromes direkt an der Düse mit 2l/min für 30 min über ein mit Derivatisierungsmittel imprägniertes Röhrchen geleitet. Die Isocyanatmenge wurde dann mittels HPLC bestimmt (Doppelbestimmung).
In der Tabelle 3 sind die Emissionswerte beim Einsatz der verschiedenen Carbodiimide zusammengefasst:

**Tabelle 3**

| **Bsp. Nr** | **12** | **13** | **14** | **15** | **16** |
|---|---|---|---|---|---|
| | V | V | V | V | E |
| **Menge CDI** [%] | 0 | 1,5 | 1,5 | 1,5 | 1,5 |
| **CDI** | - | **CDI 1** | **CDI 2** | **CDI 3** | **CDI 4** |
| **IsocyanatKonzentration [ppm]** | - | 3440/3450 | 960/950 | 480/480 | 240/230 |

Es zeigt sich, dass die polymeren Carbodiimide aus der erfindungsgemäßen Zusammensetzung ein extrem verbessertes Emissionsverhalten zeigen.

## Patentansprüche

1. Zusammensetzung, enthaltend mindestens einen Polyester und mindestens ein polymeres Carbodiimide nach Formel (I)

$$R^1\text{-}R^2\text{-}(\text{-}N{=}C{=}N\text{-}R^2\text{-})_m\text{-}R^1 \qquad \text{(I)},$$

in dem

m = 2 bis 6, bevorzugt 3 bis 5, ganz besonders bevorzugt 3 bis 4 ist
$R^1$ = -NHCONHR$^3$, -NHCONR$^3$R$^4$ oder -NHCOOR$^5$ ist,
wobei $R^3$ und $R^4$ gleich oder verschieden sind und einen $C_1$-$C_{12}$-Alkyl-, $C_6$-$C_{12}$-Cycloalkyl-, $C_7$-$C_{18}$-Aralkyl- oder $C_6$ - $C_{18}$ -Arylrest darstellen und
$R^5$ einem $C_1$ - $C_{22}$ - Alkyl-, $C_6$ - $C_{12}$ -Cycloalkyl-, $C_6$ - $C_{18}$ -Aryl oder
$C_7$ - $C_{18}$ -Aralkylrest, sowie einem ungesättigten Alkylrest mit 2 - 22 oder einem Alkoxypolyoxy-$C_1$-$C_{12}$-alkylenrest entspricht,
und
$R^2$ = $C_6$ - $C_{18}$ -Arylen, $C_1$-$C_{12}$- Alkyl und/oder $C_6$- $C_{18}$-Aryl-substituierte $C_6$-$C_{30}$-Arylene,

mit einer zahlenmittleren Molmasse $M_n$ von > 1000 bis < 2000 g/mol, bestimmt mittels GPC, gemessen in Tetrahydrofuran (THF) gegen Polystyrol als Standard.

2. Zusammensetzung enthaltend mindestens einen Polyester und mindestens ein polymeres Carbodiimid mit einer zahlenmittleren Molmasse $M_n$ von > 1000 bis < 2000 g/mol nach Formel (II)

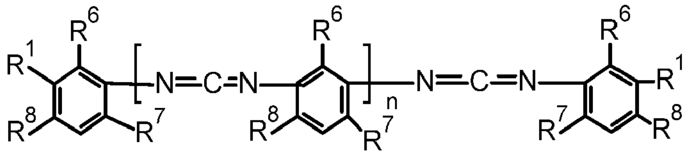

(II)

bei denen $R^1$ gleich oder verschieden sein können und ausgewählt ist aus der Gruppe der $NHCONHR^3$, $-NHCONR^3R^4$ oder-$NHCOOR^5$,

wobei $R^3$ und $R^4$ gleich oder verschieden sind und einen $C_1$-$C_{12}$-Alkyl-, $C_6$-$C_{12}$-Cycloalkyl-, $C_7$ - $C_{18}$ -Aralkylrest - oder Arylrest darstellen,

$R^5$ einem $C_1$ - $C_{22}$ - Alkyl-, $C_6$ - $C_{12}$ -Cycloalkyl-, $C_6$ - $C_{18}$ -Aryl oder $C_7$ - $C_{18}$-Ara-Ikylrest, sowie einem ungesättigten Alkylrest mit 2 - 22, bevorzugt 12-20, besonders bevorzugt 16-18 Kohlenstoffatomen, oder ein Alkoxypolyoxy-$C_1$-$C_{12}$-alkylenrest entspricht,

$R^6$, $R^7$ und $R^8$ jeweils unabhängig für Methyl- oder Ethyl steht, aber nur maximal einer der Reste $R^6$, $R^7$ und $R^8$ Methyl ist und n 1 bis 5 bedeutet.

**3.** Zusammensetzung nach Anspruch 1 oder 2, **dadurch gekennzeichnet, dass** es sich bei dem Polyester um Polyethylenterephthalat (PET), Polyethylennaphthalat (PEN), Polybutylenterephthalat (PBT), Polytrimethyleneterephthalat (PTT) und/oder Polycyclohexandimethanol-terephthalat (PCT) handelt, sowie esterbasierte thermoplastische Elastomere bevorzugt TPE-U oder TPE-E sowie biobasierte und/oder bioabbaubare bzw. kompostierbare Polyester vorzugsweise Polybutylenadipattherephthalat PBAT, Polylactide (PLA) oder Polyhydroxyalkoholate (PHA).

**4.** Folie, enthaltend mindestens einen Polyester und 0,5 - 2,5 Gew.%, vorzugsweise 1,0 - 2,0 Gew.% mindestens eines polymere Carbodiimids der Formel (I) oder (II) mit einer zahlenmittleren Molmasse $M_n$ von > 1000 bis < 2000 g/mol, bezogen auf den Polyester.

**5.** Folie nach Anspruch 4, **dadurch gekennzeichnet, dass** diese biaxial orientiert ist.

**6.** Solarzellenmodul, enthaltend mindestens eine Folie nach Anspruch 4 oder 5, vorzugsweise als Rückseitenabdeckung.

**7.** Verwendung einer Folie nach Anspruch 4 oder 5 zum Abdichten der Solarzelle.

Europäisches Patentamt / European Patent Office / Office européen des brevets

## EUROPÄISCHER RECHERCHENBERICHT

Nummer der Anmeldung: EP 16 17 5623

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2016/071347 A1 (RHEIN CHEMIE RHEINAU GMBH [DE]) 12. Mai 2016 (2016-05-12)<br>* Seite 1, Zeilen 2-4 *<br>* Seite 1, Zeile 26 - Seite 2, Zeile 11 *<br>* Seite 3, Zeilen 4-8 *<br>* Seite 6, Zeilen 15-24 *<br>* Seite 8, Zeilen 10-13 *<br>* Verbindung (I) *<br>* Ansprüche 1, 6, 10, 13-15 *<br>----- | 1,3-5,7 | INV.<br>C08K5/29<br>C08J5/18<br>C08L67/02<br>C08L79/00 |
| X,D<br><br>Y | EP 2 262 000 A1 (TEIJIN DUPONT FILMS JAPAN LTD [JP]) 15. Dezember 2010 (2010-12-15)<br>* Absätze [0005], [0006], [0015], [0023] *<br>* Ansprüche 1, 2, 5 *<br>----- | 5<br><br>6 | |
| X<br><br>Y | EP 2 803 660 A1 (RHEIN CHEMIE RHEINAU GMBH [DE]) 19. November 2014 (2014-11-19)<br>* Absätze [0006], [0011], [0012], [0032] *<br>* Verbindung (I) *<br>* Ansprüche 1, 7, 8, 12 *<br>----- | 1-3<br><br>6 | RECHERCHIERTE SACHGEBIETE (IPC) |
| X | WO 96/17011 A1 (BASF AG [DE]; HEITZ THOMAS [DE]; HEYM MANFRED [DE]; MUEHLBACH KLAUS [D) 6. Juni 1996 (1996-06-06)<br>* Seite 5, Zeilen 20-25 *<br>* Seite 6, Zeilen 23-26 *<br>* Seite 13, Zeilen 20-22 *<br>* Seite 23, Zeilen 30-34 *<br>* Verbindungen (I),(II) *<br>* Beispiele 1-13 *<br>* Ansprüche 1, 3, 4, 8 *<br>-----<br>-/-- | 1,3,4 | C08K<br>C08J<br>C08L |

Der vorliegende Recherchenbericht wurde für alle Patentansprüche erstellt

1

| Recherchenort | Abschlußdatum der Recherche | Prüfer |
|---|---|---|
| München | 31. Oktober 2016 | Vandoolaeghe, P |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.........................................................
& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 16 17 5623

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 101 46 328 A1 (BASF AG [DE]) 10. April 2003 (2003-04-10) * Absätze [0001], [0002], [0007], [0014], [0073], [0078] * * Verbindung (VI) * * Beispiele F-1-F-5; Tabellen 1, 2 * * Ansprüche 1, 3, 8 * ----- | 1,3,4 | |
| | | | RECHERCHIERTE SACHGEBIETE (IPC) |

1

Der vorliegende Recherchenbericht wurde für alle Patentansprüche erstellt

| Recherchenort | Abschlußdatum der Recherche | Prüfer |
|---|---|---|
| München | 31. Oktober 2016 | Vandoolaeghe, P |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 16 17 5623

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-10-2016

| Im Recherchenbericht angeführtes Patentdokument | Datum der Veröffentlichung | Mitglied(er) der Patentfamilie | Datum der Veröffentlichung |
|---|---|---|---|
| WO 2016071347 A1 | 12-05-2016 | EP 3018124 A1 | 11-05-2016 |
| | | WO 2016071347 A1 | 12-05-2016 |
| EP 2262000 A1 | 15-12-2010 | CN 101983432 A | 02-03-2011 |
| | | EP 2262000 A1 | 15-12-2010 |
| | | JP 5400762 B2 | 29-01-2014 |
| | | KR 20110000563 A | 03-01-2011 |
| | | TW 201000555 A | 01-01-2010 |
| | | WO 2009123357 A1 | 08-10-2009 |
| EP 2803660 A1 | 19-11-2014 | AU 2014267409 A1 | 07-01-2016 |
| | | CA 2909890 A1 | 20-11-2014 |
| | | CN 105228980 A | 06-01-2016 |
| | | EP 2803660 A1 | 19-11-2014 |
| | | EP 2997010 A1 | 23-03-2016 |
| | | JP 2016524635 A | 18-08-2016 |
| | | KR 20160020434 A | 23-02-2016 |
| | | SG 11201508680V A | 27-11-2015 |
| | | US 2016096951 A1 | 07-04-2016 |
| | | WO 2014184116 A1 | 20-11-2014 |
| WO 9617011 A1 | 06-06-1996 | AT 189468 T | 15-02-2000 |
| | | DE 4442724 A1 | 05-06-1996 |
| | | EP 0794974 A1 | 17-09-1997 |
| | | US 5733959 A | 31-03-1998 |
| | | WO 9617011 A1 | 06-06-1996 |
| DE 10146328 A1 | 10-04-2003 | KEINE | |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 2262000 A
- EP 2748234 A
- EP 2031662 A